# EUROPEAN PATENT SPECIFICATION

(11) **EP 2 975 917 B1**
(45) Date of publication and mention of the grant of the patent: **11.11.2020**
(21) Application number: 15175390.2
(22) Date of filing: 06.07.2015
(51) Int. Cl.: H05K 3/30, H05K 3/32

(54) **LASER WELDING OF THRU-HOLE ELECTRICAL COMPONENTS**
LASERSCHWEISSEN VON BEDRAHTETEN ELEKTRISCHEN KOMPONENTEN
SOUDAGE AU LASER DE COMPOSANTS ÉLECTRIQUES PERFORANTS

(30) Priority: 17.07.2014 US 201414333774
(43) Date of publication of application: 20.01.2016
(73) Proprietor: Delphi Technologies IP Limited, St. Michael (BB)
(72) Inventor: CHOW, Kin Yean, 681692 Singapore (SG)
(74) Representative: Delphi France SAS

(56) References cited:
- DE-A1-102008 002 969
- JP-A- 2001 332 329
- JP-A- 2002 025 639
- US-A1- 2007 212 907
- US-A1- 2013 312 257

## Description

### TECHNICAL FIELD OF INVENTION

This disclosure generally relates to a circuit board assembly, and more particularly relates to features that allow for electrically connecting a thru-hole component to a circuit board assembly by laser welding.

### BACKGROUND OF INVENTION

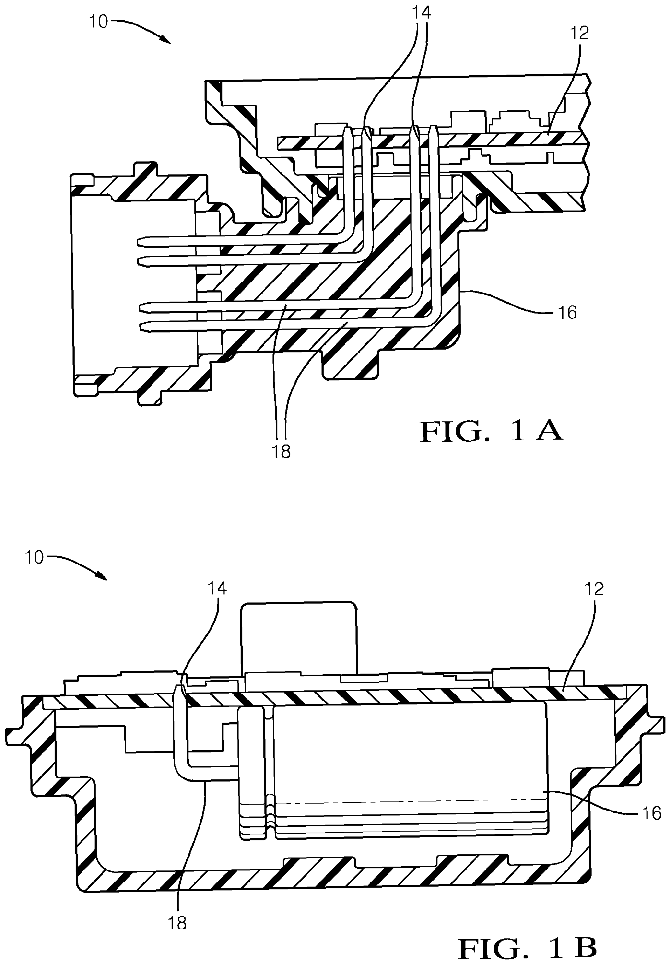

Thru-hole technology is used when an electrical component is too large for surface mounting. Examples of large electrical components include a connector (Fig. 1A) and a capacitor (Fig. 1B). If all or most of the other electrical components that make up a circuit board assembly are attached to a printed circuit board using surface mount technology, a secondary soldering operation to connect the large components to the printed circuit board is undesirable as it adds cost to the assembly.

It has been observed for automotive applications that soldering of thru-hole connections may provide adequate performance for vibration and mechanical shock resistance. However, soldering may not provide adequate performance for thermal shock resistance. Furthermore, it has been observed that in some instances the removal of lead (Pb) from solder further reduces the thermal shock resistance of a solder joint. What is needed is a cost effective means to electrically connect a thru-hole type component to a printed circuit board. US Patent Application No 2013/512257 describes a resilient locking method to connect a component pin to a PCB and Japanese patent document JP 2002/025639 discloses laser welding of a pin of an electronic component to a PCB.

### SUMMARY OF THE INVENTION

In accordance with one embodiment, a circuit board assembly is provided. The assembly includes a printed circuit board and a component. The printed circuit board includes a plated thru-hole through the printed circuit board. The component includes a lead to interconnect the component to the printed circuit board. The lead is formed to define an opening through the lead. The lead is placed into the plated thru-hole such that at least part of the opening is within the plated thru-hole. The lead is laser welded to the plated thru-hole.

Further features and advantages will appear more clearly on a reading of the following detailed description of the preferred embodiment, which is given by way of non-limiting example only and with reference to the accompanying drawings.

### BRIEF DESCRIPTION OF DRAWINGS

The present invention will now be described, by way of example with reference to the accompanying drawings, in which:
Figs. 1A and 1B are side views of circuit board assemblies in accordance with one embodiment;
Fig. 2 is a sectional side view of a lead of a component within a plated thru-hole of a printed circuit board of the assembly of Fig. 1 in accordance with one embodiment;
Fig. 3 is an isometric view of a lead of a component within a plated thru-hole of a printed circuit board of the assembly of Fig. 1 in accordance with one embodiment;
Fig. 4 is an isometric sectional view of the circular lead of Fig. 3 in accordance with one embodiment; and
Fig. 5 is an isometric view of the rectangular lead of Fig. 3 in accordance with one embodiment.

### DETAILED DESCRIPTION

It is proposed herein to employ laser energy to weld contact surfaces between pins or wires (i.e. the leads) of relatively large electrical components to a plated thru-hole of a printed circuit board (PCB). After a lead of the large electrical component is inserted into the thru-hole of the PCB with small interference, a laser beam is directed to the tip of the lead. That is, the laser energy will not directed to the plated thru-hole of the PCB as the heat of the laser beam energy may affect the near-by copper traces and electrical components upon the circuit board assembly. The melted copper from the lead of the large electrical component is welded to the copper barrel of the plated thru-hole of the PCB by means of heat conduction from the lead to the barrel portion of the printed thru-hole. The size of the lead is about the same size as the plated thru-hole. This is to ensure contact between the lead and the plated thru-hole. An opening feature within the lead is provided to minimize the heat conduction away from where the laser is directed. That is, the opening inhibits heat conduction toward to the other end of the lead during laser welding. In general, the mechanical strength of the interconnection by laser welding is governed by the material strength of the copper alloy.

Preferably, the contact between the lead and the plated thru-hole will be an interference fitted. By way of example and not limitation, it is preferable that any gap between the lead and the plated thru-hole is less than 0.02 millimeters (mm) as it has been observed that such a sized gap can be filled by the melted copper from the lead. The thickness of the barrel portion of the printed thru-hole should be adequately large to cater for the melt thickness of 0.02mm. The advantages of laser welding as described herein are: the mechanical strength of the interconnect has been observed to be stronger; the reliability of the interconnect has been observed to be improved for vibration, mechanical shock, and thermal shock resistance; and the material and processing costs are be reduced as compared to soldering.

Figs. 1A and 1B illustrate non-limiting examples of a circuit board assembly, hereafter referred to as the assembly 10. The assembly 10 includes a printed circuit board, hereafter the PCB 12, which includes a plated thru-hole 14 through the printed circuit board (PCB 12). The PCB 12 may be formed of the well-known circuit board material FR-4, and the plated thru-hole 14 is advantageously formed of copper or a copper alloy, along with conductor paths on the PCB that provide routes for electricity to propagate to and from the plated thru-hole 14.

The assembly 10 also includes a component 16 such as, but not limited to, a connector as illustrated in Fig. 1A, or a capacitor as illustrated in Fig. 1B. While many electrical components are small enough to be mounted or attached to the PCB 12 using surface mount technology, the improvement to the technical arts described herein is directed to components that are generally larger than typical surface mount type components so often use thru-hole technology as opposed to surface mount technology to electrically connect the component 16 to the PCB 12 at the plated thru-hole 14.

Accordingly, the component 16 includes a lead 18 to interconnect the component 16 to the PCB 12. As used herein, the term 'lead' covers lead-frames or pins which are terms commonly used to refer to the electrically conductive pieces in a connector, and includes wires or terminals which are terms commonly used to refer to the electrically conductive pieces of electronic components, and includes other terms commonly used to describe some feature or object used as part of a thru-hole type interconnection to a circuit board. The lead 18 is advantageously formed of copper or a copper alloy. The material selected for the lead 18 and the plated thru-hole 14 need to be materials that are readily welded together, as will become apparent in the description below.

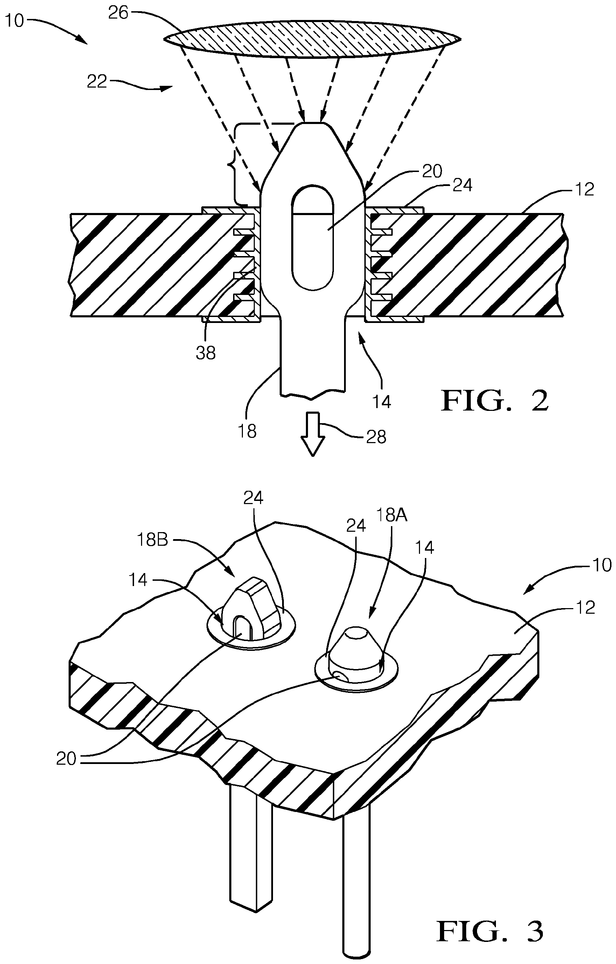

Fig. 2 further illustrates non-limiting features of the assembly 10. As will become apparent in the description that follows, the lead 18 is advantageously formed to define an opening 20 through the lead 18. The lead 18 may be formed using well-known manufacturing techniques which are sometimes referred to as micro-forming. In this non-limiting example the opening 20 has the appearance of an eye of a sewing needle, but other shapes are contemplated. When the assembly 10 is formed, the lead 18 is placed into the plated thru-hole 14 such that at least part of the opening 20 is within the plated thru-hole 14. Once in this position, the lead 18 is laser welded to the plated thru-hole 14.

Preferably, the laser weld is formed by laser energy 22 projected onto or directed toward a tip portion 40 of the lead 18. That is, the laser energy 22 is focused such that the laser energy 22 is not projected onto or directed toward an annular ring 24 of the plated thru-hole. As such, the laser weld is formed by direct heating of the lead 18, and indirect heating of the plated thru-hole 14, where the indirect heating comes from heat dissipated by the lead 18 to the plated thru-hole 14. The laser energy 22 may be focused by a lens 26 as will be recognized by those in the art. While the illustration suggests that the laser energy 22 is broadly distributed over the surface of the tip portion 40, it is contemplated that the laser energy 22 could be scanned across the surface of the tip portion 40 such that only a portion of the tip portion 40 is 'illuminated' by the laser energy 22 at any moment. Also, the laser energy may be non-uniformly distributed in order to achieve a uniform temperature along the interface between the lead 18 and the plated thru-hole 14. The non-uniform distribution of energy is preferred as the presence of the opening 20 may cause non-uniform temperature distribution.

The opening 20 is provided to reduce the cross section of the heat path proximate to the opening 20 and thereby reduce the amount of heat that travels down the lead 18 in the direction shown by arrow 28. If the lead 18 does not have the opening 20, then the amount of heat conducted away from the interface between the lead 18 and the plated thru-hole 14 is increased and so more energy is needed to form a weld joint between the lead 18 and the plated thru-hole 14. In other words, the opening 20 restricts the amount of heat conducted away from the tip portion 40 so that the weld joint between the lead 18 and the plated thru-hole 14 can be more quickly formed.

Fig. 3 further illustrates non-limiting features of the assembly 10. Two different lead configurations are shown: a circular lead 18A on the right, and a rectangular lead 18B on the left. The opening 20 for each configuration is shown as having most of the opening 20 within the plated thru-hole 14. In other words, most of the opening 20 is below the annular ring 24. If the opening 20 extends too far out of the plated thru-hole 14 and above the annular ring 24, the amount of heat coupled to the interface between the lead 18 (18A or 18B) and the plated thru-hole 14 may be reduced. On the other hand, if the top of the opening 20 is too far below the annular ring 24, the amount of the laser energy 22 and time necessary to heat the lead 18 to a temperature sufficient to form a weld joint between the lead 18 (18A or 18B) and the plated thru-hole 14 may be undesirably increased. The amount of the laser energy 22, the time that the laser energy is applied, the location of the opening 20 relative to the annular ring 24, and the general shape of the lead 18 can be optimized using computer modeling and/or empirical testing combined with a micrographic analysis of the weld joint formed a between the lead 18 (18A or 18B) and the plated thru-hole 14.

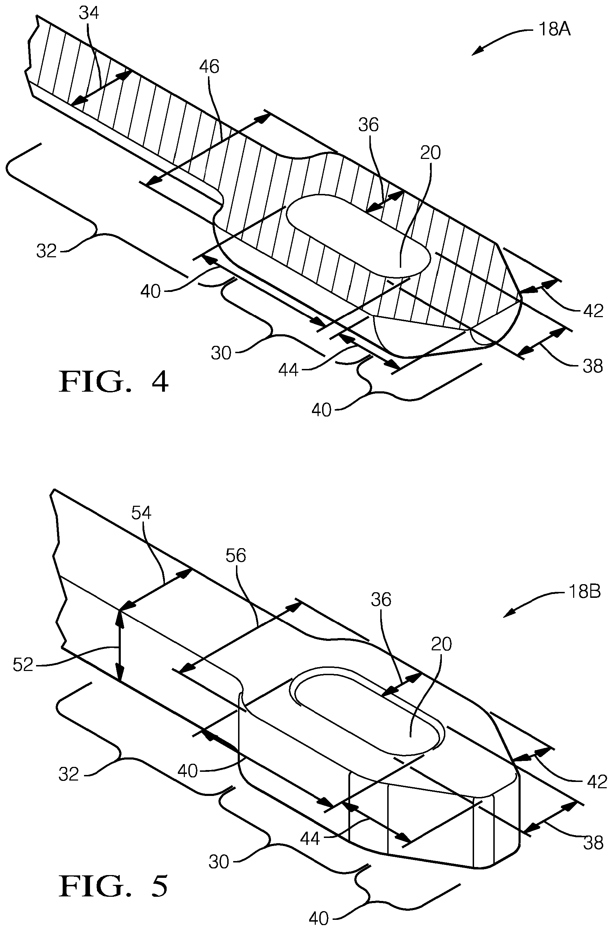

Fig. 4 further illustrates non-limiting details of the circular lead 18A. The opening 20 is within a body portion 30 of the lead 18 (e.g. - the circular lead 18A), and the body portion 30 is characterized as circular, i.e. - round. Having the body portion 30 be circular may be advantageous as the area of welded contact between the lead 18 and the plated thru-hole 14 is maximized. In this example an unformed portion 32 is also shown as being circular, however other shapes are contemplated such as square or hexagonal. If the component 16 is a capacitor such as an aluminum electrolytic capacitor, the lead 18 is typically circular or round. By way of example and not limitation - a suitable value for the wire diameter 34 is six-hundred-forty micrometers (640um); a suitable value for the wall thickness 36 is 384um; a suitable value for the opening width is 512um; and a suitable value for the opening length is 1280um. The tip portion 40 may have a frustoconical shape with a suitable value for the taper angle 42 of twenty-five degrees angle (25° angle) with a suitable value for the tip length 44 of 640um.

Preferably, the body portion 30 has a body diameter 46 selected to provide an interference fit with the plated thru-hole 14. The tighter the fit (i.e. the more interference there is), the better heat is transferred from the lead 18 to the barrel portion 38 of the plated thru-hole 14. However, it is recognized that too much interference can damage the plated thru-hole 14, possibly breaking the electrical connection with the annular ring 24 and/or other conductor layers within the PRB 12.

In this example above, the body diameter 46 is greater than a wire diameter 34 of the lead 18. This configuration is advantageous as it allows the opening 20 to be more readily formed and the smaller size of the unformed portion 32 conducts less heat away from the body portion 30 than would be the case if the body portion 30 and the unformed portion 32 had the same diameter.

The body portion 30 includes a tapered tip, i.e. the tip portion 40 may be tapered. Having a tapered tip is advantageous as the lead 18 is more readily aligned with the plated thru-hole 14 when being inserted, and the laser energy 22 is more readily focused on the surface of the tip portion 40 when compared to a configuration where the tip portion 40 was not tapered so the taper angle 42 was zero.

Fig. 5 further illustrates non-limiting details of the rectangular lead 18B. The opening 20 is within a body portion 30 of the lead 18 (e.g. - the rectangular lead 18B), and the body portion 30 is characterized as rectangular. Having the body portion 30 be rectangular may be advantageous as the tolerance for dimension of the body portion 30 that does not damage the plated thru-hole 14 is improved. In this example an unformed portion 32 is also shown as being rectangular, however other shapes are contemplated such as square or hexagonal or round. If the component 16 is a connector such as a header connector, the lead 18 may be rectangle or square. By way of example and not limitation - a suitable value for the lead thickness 52 is six-hundred-forty micrometers (640um); a suitable value for the lead width 54 is 960um; a suitable value for the wall thickness 36 is 384um; a suitable value for the opening width is 512um; and a suitable value for the opening length is 1280um. The tip portion 40 may have a tapered shape with a suitable value for the taper angle 42 of twenty-five degrees angle (25° angle) with a suitable value for the tip length 44 of 640um.

In this example, the body width 56 is greater than a body thickness which is the same as the lead thickness 52. The body width 56 and the body thickness are cooperatively selected to provide an interference fit with the plated thru-hole 14. In this example the body width 56 is greater than the lead width 54 of the lead 18. Preferably the lead thickness 52 is smaller than the body width 56 so the gap between the body portion 30 across the lead thickness 52 is small enough so the welding process can fill the gap.

Like the circular lead 18A previously described, the body portion 30 of the rectangular lead 18B also advantageously includes a tip portion 40 characterized as a tapered tip which provides the same advantages as described above with regard to the tip portion 40 of the circular lead 18A.

Accordingly, a circuit board assembly (the assembly 10) is provided that is well adapted for laser welding of the lead 18 into the plated thru-hole 14. This ability helps to reduce the manufacturing costs of circuit board assemblies that are mostly built with surface mount type components, but need to also connect thru-hole type components to a printed circuit board after the surface mount type components have been attached using, for example, reflow soldering. Furthermore, the welded joining of the lead 18 to the plated thru-hole 14 is more reliable during thermal shock testing.

While this invention has been described in terms of the preferred embodiments thereof, it is not intended to be so limited, but rather only to the extent set forth in the claims that follow.

## Claims

1. A circuit board assembly (10), said assembly comprising:
a printed circuit board (12) that includes a plated thru-hole (14) through the printed circuit board; and
a component (16) that includes a lead (18) to interconnect the component to the printed circuit board,
wherein the lead (18) is welded to the copper barrel of the plated thru-hole(14) of the PCB; and
wherein the circuit board assembly (10) is obtainable by:
providing a printed circuit board that includes a plated thru-hole (14) through the printed circuit board
providing a lead (18) with an opening (20) wherein the lead is about the same size as the plated-thru hole (14),
inserting the lead (18) into the plated thru-hole (14) to ensure contact between the lead and the plated thru hole, wherein at least a part of the opening (20) of the lead is within the plated thru-hole,
directing a laser beam to the tip (40) of the lead (18) to melt material of the lead thereby filling a gap between the lead and the plated thru-hole..

2. The assembly in accordance with claim 1, wherein the opening (20) is within a body portion (30) of the lead, and the body portion is characterized as having a circular cross-section.

3. The assembly in accordance with claim 2, wherein the body portion (30) has a body diameter (46) selected to provide an interference fit with the plated thru-hole (14)

4. The assembly in accordance with claim 5, wherein the body diameter (46) is greater than a wire diameter (34) of the lead.

5. The assembly in accordance with claim 2 wherein the body portion includes a tapered tip (40) .

6. The assembly in accordance with claim 1, wherein the opening is within a body portion (30) of the lead, and the body portion (30) is characterized as having rectangular cross-section.

8. The assembly in accordance with claim 7, wherein the body portion has a body width (56) greater than a body thickness (52), and the body width selected to provide an interference fit with the plated thru-hole.

9. The assembly in accordance with claim 8, wherein the body width (56) is greater than a lead width (54) of the lead.

10. The assembly in accordance with claim 7, wherein the body portion (30) includes a tapered tip.

## Patentansprüche

1. Leiterplattenanordnung (10), wobei die Anordnung aufweist:
eine Leiterplatte (12), die ein plattiertes Durchgangsloch (14) durch die Leiterplatte umfasst; und
eine Komponente (16), die eine Leitung (18) zum Verbinden der Komponente mit der Leiterplatte umfasst,
wobei die Leitung (18) an die Kupferhülse des plattierten Durchgangslochs (14) der PCB geschweißt ist; und
wobei die Leiterplattenanordnung (10) erlangt werden kann durch:
Vorsehen einer Leiterplatte, die ein plattiertes Durchgangsloch (14) durch die Leiterplatte umfasst,
Vorsehen einer Leitung (18) mit einer Öffnung (20), wobei die Leitung ungefähr dieselbe Größe hat wie das plattierte Durchgangsloch (14),
Einfügen der Leitung (18) in das plattierte Durchgangsloch (14), um einen Kontakt zwischen der Leitung und dem plattierten Durchgangsloch sicherzustellen, wobei zumindest ein Teil der Öffnung (20) der Leitung innerhalb des plattierten Durchgangslochs ist,
Leiten eines Laserstrahls zu der Spitze (40) der Leitung, um Material der Leitung zu schmelzen, um dadurch eine Lücke zwischen der Leitung und dem plattierten Durchgangsloch zu füllen.

2. Die Anordnung gemäß Anspruch 1, wobei die Öffnung (20) innerhalb eines Körperabschnitts (30) der Leitung ist und der Körperabschnitt durch einen kreisförmigen Querschnitt charakterisiert ist.

3. Die Anordnung gemäß Anspruch 2, wobei der Körperabschnitt (30) einen Körperdurchmesser (46) hat, der ausgewählt ist, um eine Presspassung mit dem plattierten Durchgangsloch (14) vorzusehen.

4. Die Anordnung gemäß Anspruch 3, wobei der Körperdurchmesser (46) größer als ein Drahtdurchmesser (34) der Leitung ist.

5. Die Anordnung gemäß Anspruch 2, wobei der Körperabschnitt eine sich verjüngende Spitze (40) umfasst.

6. Die Anordnung gemäß Anspruch 1, wobei sich die Öffnung innerhalb eines Körperabschnitts (30) der Leitung befindet und der Körperabschnitt (30) durch einen rechteckigen Querschnitt charakterisiert ist.

7. Die Anordnung gemäß Anspruch 6, wobei der Körperabschnitt eine Körperbreite (56) hat, die größer als eine Körperdicke (52) ist, und die Körperbreite ausgewählt ist, um eine Presspassung mit dem plattierten Durchgangsloch vorzusehen.

8. Die Anordnung gemäß Anspruch 7, wobei die Körperbreite (56) größer als eine Leitungsbreite (54) der Leitung ist.

9. Die Anordnung gemäß Anspruch 6, wobei der Körperabschnitt (30) eine sich verjüngende Spitze umfasst.

## Revendications

1. Assemblage à carte à circuits (10), ledit assemblage comprenant :
une carte à circuits imprimés (12) qui inclut un trou traversant métallisé (14) à travers la carte à circuits imprimés ; et
un composant (16) qui inclut un fil (18) afin d'interconnecter le composant à la carte à circuits imprimés,
dans lequel le fil (18) est soudé au cylindre de cuivre du trou traversant plaquer (14) de la carte à circuits imprimés ; et
dans lequel l'assemblage à carte à circuits (10) est capable d'être obtenu :
en fournissant une carte à circuits imprimés qui inclut un trou traversant métallisé (14) à travers la carte à circuits imprimés,
en fournissant un fil (18) avec une ouverture (20), tel que le fil à environ la même taille que le trou traversant plaquer (14),
en insérant le fil (18) dans le trou traversant métallisé (14) pour assurer un contact entre le fil et le trou traversant métallisé, tel qu'au moins une partie de l'ouverture (20) du fil est à l'intérieur du trou traversant métallisé,
et en dirigeant un faisceau laser vers la pointe (40) du fil (18) pour faire fondre du matériau du fil et remplir ainsi un intervalle entre le fil et le trou traversant métallisé.

2. Assemblage selon la revendication 1, dans lequel l'ouverture (20) est à l'intérieur d'une portion de corps (30) du fil, et la portion de corps est **caractérisée** comme ayant une section transversale circulaire.

3. Assemblage selon la revendication 2, dans lequel la portion de corps (30) présente un diamètre de corps (46) sélectionné pour assurer un engagement à interférence avec le trou traversant métallisé (14).

4. Assemblage selon la revendication 3, dans lequel le diamètre du corps (46) est plus grand qu'un diamètre (34) du fil.

5. Assemblage selon la revendication 2, dans lequel la portion de corps inclut un embout effilé (40).

6. Assemblage selon la revendication 1, dans lequel l'ouverture est à l'intérieur d'une portion de corps (30) du fil, et la portion de corps (30) est **caractérisée** comme ayant une section transversale rectangulaire.

7. Assemblage selon la revendication 6, dans lequel la portion de corps a une largeur de corps (56) plus grande qu'une épaisseur de corps (52), et la largeur de corps est sélectionnée pour assurer un engagement à interférence avec le trou traversant métallisé.

8. Assemblage selon la revendication 7, dans lequel la largeur de corps (56) est plus grande qu'une largeur (54) du fil.

9. Assemblage selon la revendication 6, dans lequel la portion de corps (30) inclut un embout effilé.
